# EUROPEAN PATENT APPLICATION

(11) **EP 2 251 717 A1**
(43) Date of publication of application: **17.11.2010**
(21) Application number: 10160856.0
(22) Date of filing: 23.04.2010
(51) Int. Cl.: G02B 3/00, B29C 33/38, H01L 27/146

(54) **Wafer level lens array and manufacturing method therefor**

(30) Priority: 14.05.2009 JP 2009117592
(71) Applicant: Fujinon Corporation, Saitama-shi, Saitama (JP); Fujifilm Corporation, Minato-ku Tokyo (JP)
(72) Inventor: Yamada, Daisuke, Saitama (JP); Nakao, Kazuhiro, Saitama (JP)
(74) Representative: Klunker . Schmitt-Nilson . Hirsch

(57) **Abstract**

Provided is a wafer level lens array, in which a plurality of lens sections arranged one-dimensionally or two-dimensionally and a substrate section connecting the lens sections are integrally made of a resin material, capable of preventing the substrate section from being deformed.

A wafer level lens array (100) includes: a plurality of lens sections (101) that are two-dimensionally arranged; a substrate section (102) that connects the lens sections (101) to each other; and a rib (104) that is disposed on the substrate section (102) and extends along the surface of the substrate section (102). The lens sections (101), the substrate section (102), and the rib (104) are integrally made of a resin material.

## Description

### BACKGROUND OF THE INVENTION

### 1. Field of the Invention

The present invention relates to a manufacturing method and a manufacturing apparatus of a wafer level lens array having a plurality of lens sections which is one-dimensionally or two-dimensionally arranged and is made of a resin material.

### 2. Description of the Related Art

In recent years, portable terminals of electronic devices such as cellular phones and PDAs (Personal Digital Assistants) are equipped with image pickup units which are small and flat. Such an image pickup unit generally includes a solid-state image pickup device such as a CCD (Charge Coupled Device) image sensor or a CMOS (Complementary Metal-Oxide Semiconductor) image sensor and lenses that form a subject image on the solid-state image pickup device.

As portable terminals become small and flat and portable terminals have spread, there is also a demand for the image pickup units mounted on these to achieve further reduction in size and thickness and an increase in productivity. In order to meet these demands, the following known method of mass-producing image pickup units may be adopted. First, a sensor array is integrally assembled with one lens array, or is integrally assembled with a plurality of lens arrays in an overlapped manner. The sensor array includes a plurality of solid-state image pickup devices which are arranged one-dimensionally or two-dimensionally and a substrate section which holds the solid-state image pickup devices. The lens array includes a plurality of lens sections which are arranged one-dimensionally or two-dimensionally in the same manner and a substrate section which holds the lenses. Subsequently, the substrate section of the lens array and the substrate section of the sensor array are cut so as to include the lens sections and solid-state image pickup devices, respectively. Hereinafter, each lens section held by the substrate section is referred to as a wafer level lens, and a group of the lens sections is referred to as a wafer level lens array.

There is a known wafer level lens or a known wafer level lens array in which a lens section made of a resin material are formed on a substrate section made of a glass (for example, refer to Japanese Patent No. 3926380 and International Publication No. 08/102648). There is also a known wafer level lens or a known wafer level lens array in which a plurality of lens sections and a substrate section connecting the lens sections to each other are integrally made of a resin material (for example, refer to International Publication No. 08/093516). As compared with the case where the substrate section is made of glass, in the case where the substrate section is made of resin, deformation tends to occur relatively frequently. When the substrate section of the wafer level lens array is deformed, there is a possibility that, for example, disadvantage of eccentricity or collapse is caused in the process of overlapping the substrate section with the sensor array or another wafer level lens array.

### SUMMARY OF THE INVENTION

The invention has been made in view of the above-mentioned situation, and it is desirable to provide a wafer level lens array, in which a plurality of lens sections arranged one-dimensionally or two-dimensionally and a substrate section connecting the lens sections are integrally made of a resin material, capable of preventing the substrate section from being deformed.
1. According to a first aspect of the invention, a wafer level lens array includes: a plurality of lens sections that are one-dimensionally or two-dimensionally arranged; a substrate section that connects the lens sections to each other; and a rib that is disposed on the substrate section and extends along the surface of the substrate section. The lens sections, the substrate section, and the rib are integrally made of a resin material.
2. According to a second aspect of the invention, there is provided a method of manufacturing a wafer level lens array including a plurality of lens sections that are one-dimensionally or two-dimensionally arranged, a substrate section that connects the lens sections to each other, and a rib that is disposed on the substrate section and extends along the surface of the substrate section. The lens sections, the substrate section, and the rib are integrally made of a resin material. The method includes the steps of: forming a master that has the same shape as the wafer level lens array; forming a first mold that has a transfer surface fitted to one side surface of the master and a second mold that has a transfer surface fitted to an opposite side surface of the master; and curing the resin material that is softened between the transfer surface of the first mold and the transfer surface of the second mold.

According to the aspects of the invention, by using the rib, it is possible to increase a second moment of the area of the substrate section around the axis intersecting with the rib. As a result, it is possible to prevent deformation of the substrate section around the axis.

Further, according to the aspects of the invention, the wafer level lens array is manufactured in a way that the molds therefor are formed by the master having the same surface shape and the resin material is shaped by the molds. By variously modifying the shape and the arrangement of the rib of the master, it is possible to variously modify the shape and the position of the rib of the wafer level lens array. As a result, it is possible to manufacture a wafer level lens array suitable for preventing the substrate section from being deformed.

### BRIEF DESCRIPTION OF THE DRAWINGS

Figs. 1A and 1B are views illustrating an example of a wafer level lens array according to an embodiment of the invention, where Fig. 1A is a top plan view of the wafer level lens array and Fig. 1B is a sectional view of the wafer level lens array taken along the line B-B in Fig. 1A;
Figs. 2A to 2F are sectional views illustrating modified examples of the wafer level lens array of Figs. 1A and 1B;
Fig. 3 is a top plan view illustrating a modified example of the wafer level lens array of Figs. 1A and 1B;
Fig. 4 is a top plan view illustrating a modified example of the wafer level lens array of Figs. 1A and 1B;
Fig. 5 is a top plan view illustrating a modified example of the wafer level lens array of Figs. 1A and 1B;
Fig. 6 is a top plan view illustrating a modified example of the wafer level lens array of Figs. 1A and 1B;
Fig. 7 is a top plan view illustrating a modified example of the wafer level lens array of Figs. 1A and 1B;
Fig. 8 is a top plan view illustrating a modified example of the wafer level lens array of Figs. 1A and 1B;
Fig. 9 is a top plan view illustrating a modified example of the wafer level lens array of Figs. 1A and 1B;
Fig. 10 is a front view illustrating a schematic configuration of a manufacturing apparatus of the wafer level lens array of Figs. 1A and 1B;
Figs. 11A to 11D are sectional views illustrating a process of manufacturing the wafer level lens array using the manufacturing apparatus of Fig. 10;
Fig. 12 is a graph illustrating a general relationship between time T and viscosity (hardness) µ of a resin material;
Fig. 13 is a sectional view illustrating a master of the wafer level lens array of Figs. 1A and 1B; and
Fig. 14 is a view illustrating a frame format of a method of manufacturing a mold by using the master of Fig. 13.

### DESCRIPTION OF THE PREFERRED EMBODIMENTS

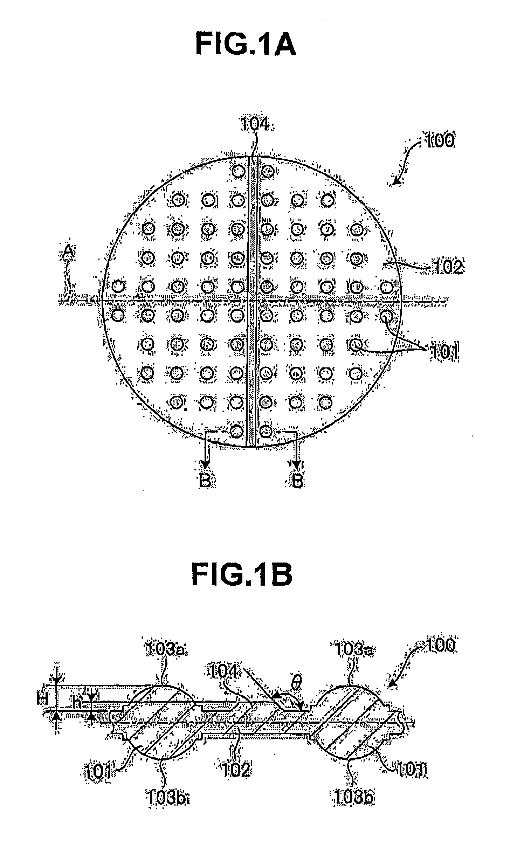

Figs. 1A and 1B show a wafer level lens array 100 including: a plurality of lens sections 101 that are two-dimensionally arranged at a predetermined pitch; a substrate section 102 that has an approximately circular shape connecting the lens sections 101; and a rib 104 that is disposed on the substrate section 102 and extends along the surface of the substrate section 102.

The lens sections 101, the substrate section 102, and the rib 104 are integrally made of an optically transparent resin material. As the resin material of the lens sections 101, the substrate section 102, and the rib 104, for example, a thermosetting epoxy resin, a thermosetting acryl resin, a photo-curable epoxy resin, a photo-curable acryl resin, or the like is used.

Further, it may be possible to use an organic inorganic hybrid material formed by distributing inorganic microparticles in the above-mentioned resin. As inorganic microparticles, for example, there are oxide microparticles, sulfide microparticles, selenide microparticles, and telluride microparticles. More specifically, for example, there are microparticles of zirconium oxide, titan oxide, zinc oxide, tin oxide, zinc sulfide, and the like.

The inorganic microparticles may be used alone, and may be used by combining two or more kinds thereof. Further, the inorganic microparticles may be compounds formed of a plurality of components. In addition, for the various purposes of reducing photocatalytic activity, reducing a absorption rate, and so on, the inorganic microparticles may be coated with a different metal, surface layers of these may be coated with a different metal oxide such as silica and alumina, and surfaces of these may be modified by a silane coupling agent, a titanate coupling agent, dispersive agents, which have an organic acid (carboxylic acids, sulfone acids, phosphoric acids, phosphoric acids, and the like) or an organic acid group, and the like.

In a case where the number average particle size of the inorganic microparticles is too small, the material characteristics may change. Further, in a case where a difference in refractive indices between the resin matrix and the inorganic microparticles is too large, Rayleigh scattering has a remarkable influence on these. Hence, the size is preferably in the range of 1 nm to 15 nm, more preferably in the range of 2 nm to 10 nm, and particularly preferably in the range of 3 nm to 7 nm. Further, it is more preferable that the particle size distribution of the inorganic particles should be denser. The method of defining such monodispersed particles is various, but for example, the numerical value range as prescribed in JP-A-2006-160992 satisfies the preferable particle size distribution range. Here, the above-mentioned number average first order particle size can be measured by the X-ray diffractometer (XRD), the transmission-type electron microscope (TEM), or the like.

The refractive index of the micro particles is, at 22°C and at a wavelength of 589 nm, preferably in the range of 1.90 to 3.00, more preferably in the range of 1.90 to 2.70, and particularly preferably in the range of 2.00 to 2.70. A content of the micro particles relative to the resin matrix is, in view of transparency and an increase in refractive index, preferably 5 weight% or more, more preferably in the range of 10 to 70 weight%, and particularly preferably in the range of 30 to 60 weight%.

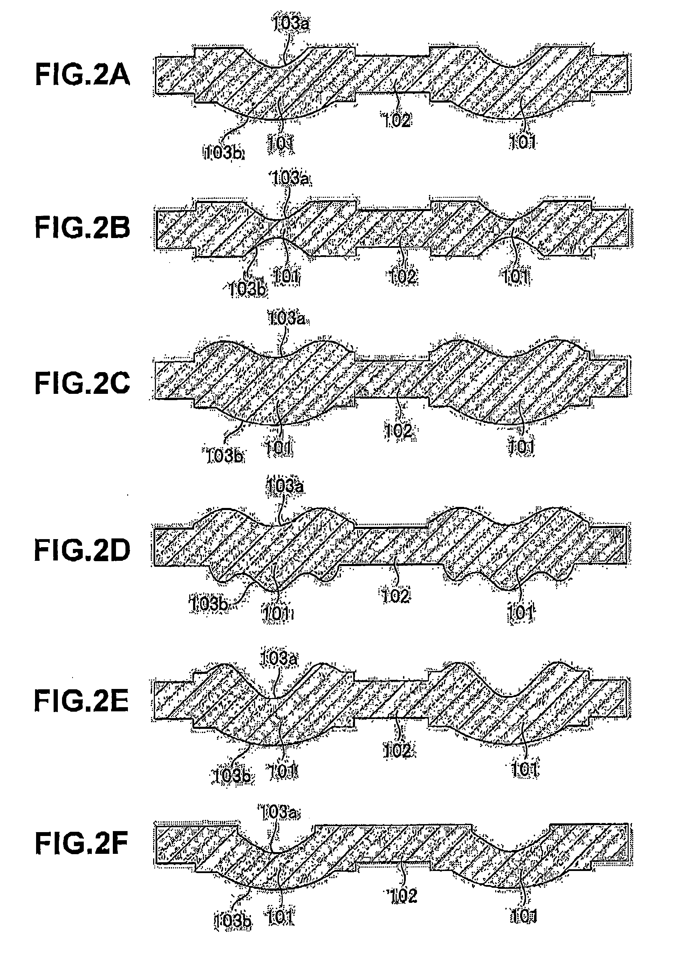

Each lens section 101 is configured so that predetermined lens surfaces 103a and 103b are formed on both sides thereof, and in the example shown in the drawing, all the surfaces are formed as convex spherical surfaces. Furthermore, the lens surfaces 103a and 103b are not limited to the convex spherical surfaces, and may be concave spherical surfaces, aspheric surfaces, or various combinations of the convex spherical surface, the concave spherical surface, and the aspheric surface. Fig. 2A to 2F show other examples of the lens section 101.

The lens section 101 of the modified example shown in Fig. 2A is configured so that the one side lens surface 103a is concave and the opposite side lens surface 103b is convex. The lens section 101 of the modified example shown in Fig. 2B is configured so that all the lens surfaces 103a and 103b are concave.

The lens section 101 of the modified example shown in Fig. 2C is configured so that the one side lens surface 103a has convex and concave portions and the opposite side lens surface 103b is convex. The lens section 101 of the modified example shown in Fig. 2D is configured so that all the lens surfaces 103a and 103b have convex and concave portions.

The lens section 101 of the modified example shown in Fig. 2E is configured so that the one side lens surface 103a has convex and concave portions and the bottom of the concave portion is located inside the substrate section 102 in the thickness direction. In addition, the opposite side lens surface 103b is convex.

The lens section 101 of the modified example shown in Fig. 2F is configured so that the one side lens surface 103a is concave and the entirety of the surface is located inside the substrate section 102 in the thickness direction. In addition, the opposite side lens surface 103b is convex.

Since the lens section 101 and the substrate section 102 are integrally made of the resin material, it is possible to employ a lens shape in which a part of the one side lens surface 103a of the lens section 101 is depressed in the substrate section 102 in the thickness direction as shown in Fig. 2E. Alternatively, it is possible to employ a lens shape in which the entirety of the one side lens surface 103a of the lens section 101 is depressed in the substrate section 102 in the thickness direction as shown in Fig. 2F. As a result, a degree of freedom in design of the lens section 101 increases.

Referring to Figs. 1A and 1B again, in the example shown in the drawing, the rib 104 is provided on one side surface of the substrate section 102 so as to extend linearly and across the substrate section 102. By using the rib 104, the second moment of the area of the substrate section 102 around the axis intersecting with the rib 104 increases, thereby preventing deformation of the substrate section 102 around the axis. In particular, deformation of the substrate section 102 around the axis A orthogonal to the rib 104 is prevented, that is, the substrate section 102 is prevented from being deformed in an arc shape along the rib 104. For example, the deformation of the substrate section 102, which is experimentally produced, is inspected, and the rib 104 is disposed along the arc shape in which the substrate section tends to be deformed.

The angle θ formed between the side surface of the rib 104 and the surface of the substrate section 102 is a right or obtuse angle (90°≤θ<180°). This is for easily demolding the rib 104 from the mold for shaping the resin material in the process of manufacturing the wafer level lens array 100 to be described later. The sectional shape of the rib 104 having the angle θ which is a right or obtuse angle is not particularly limited, but may be an appropriate shape such as a square shape, a rectangular shape, a trapezoidal shape, a triangular shape, or an arc shape.

Further, the height h of the rib 104 from the surface of the substrate section 102 is set to be lower than the height H of the apex of the lens surface 103a of each lens section 101. As described above, in the manufacturing of the image pickup unit, the wafer level lens array 100 is combined with the sensor array or another wafer level lens array in an overlapped manner. However, when the height h of the rib 104 is lower than the height H of the lens section 103, there is no restriction on the space between the lens surface 103a of the lens section 103 and another wafer level lens array or the sensor array.

The number, the planar shape, and the arrangement of the ribs 104 are not limited to the above. Hereinafter, modified examples of the wafer level lens array 100 will be described in which the number, the planar shape, and the arrangement of the ribs 104 are variously modified.

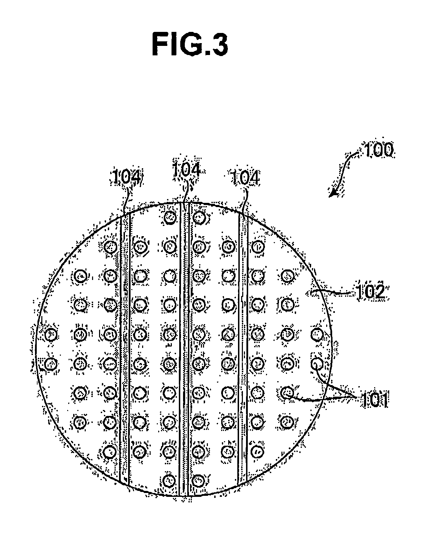

In the wafer level lens array 100 according to the modified example shown in Fig. 3, a plurality of ribs 104, which linearly extend in parallel to each other, is provided on one side surface of the substrate section 102. With such a configuration, it is possible to further increase the second moment of the area of the substrate section 102 around the axis intersecting with the ribs 104. As a result, it is possible to prevent the deformation of the substrate section 102 more reliably.

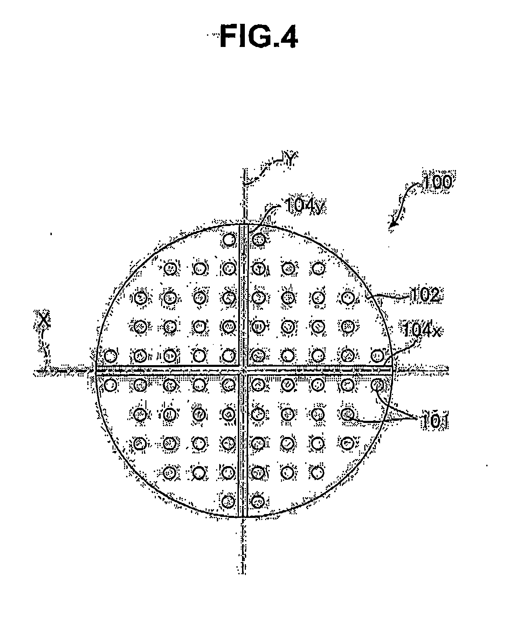

In the wafer level lens array 100 according to the modified example shown in Fig. 4, one rib 104x, which linearly extends in a predetermined direction (hereinafter referred to as a direction of X axis), and one rib 104y, which linearly extends in a direction orthogonal thereto (hereinafter referred to as a direction of Y axis), are provided on one side surface of the substrate section 102. With such a configuration, the rib 104y, which extends in the direction of Y axis, prevents the deformation of the substrate section 102 around the axis X. In addition, the rib 104x, which extends in the direction of X axis, prevents the deformation of the substrate section 102 around the axis Y. As described above, it is possible to prevent the various kinds of deformation of the substrate section 102 by using the ribs 104x and 104y in a mutually complementary manner.

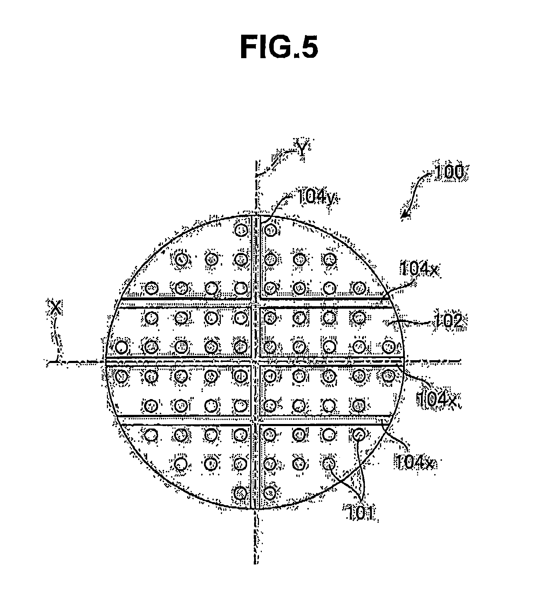

In the wafer level lens array 100 of the modified example shown in Fig. 5, a plurality of ribs 104x, which linearly extend in parallel to each other in the direction of X axis, and one rib 104y, which extends in the direction of Y axis, are provided on the one side surface of the substrate section 102. With such a configuration, the second moment of the area of the substrate section 102 around the axis Y becomes larger than the second moment of the area of the substrate section 102 around the axis X. Accordingly, this configuration is particularly suitable, for example, for a case where the deformation of the substrate section 102 around the Y axis tends to occur more frequently.

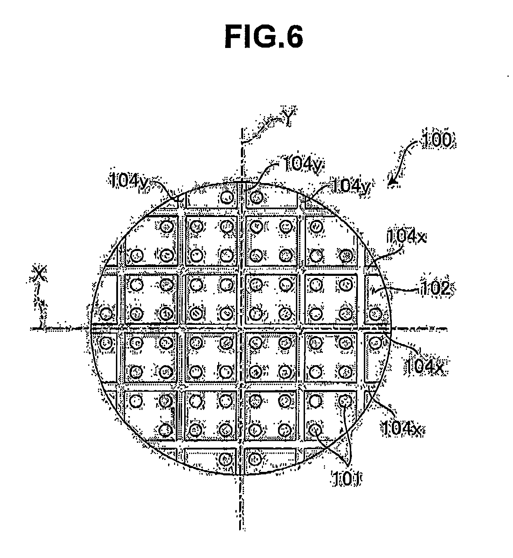

In the wafer level lens array 100 according to the modified example shown in Fig. 6, a plurality of ribs 104x of the first group, which linearly extends in parallel to each other in the direction of X axis, and a plurality of ribs 104y of the second group, which linearly extends in parallel to each other in the direction of Y axis, are provided on the one side surface of the substrate section 102. The plurality of ribs 104x of the first group and the plurality of ribs 104y of the second group are orthogonal to each other, and are arranged in a matrix. With such a configuration, the plurality of ribs 104y of the second group, which extends in the direction of Y axis, prevents the deformation of the substrate section 102 around the axis X. In addition, the plurality of ribs 104x of the first group, which extends in the direction of X axis, prevents the deformation of the substrate section 102 around the axis Y. As described above, it is possible to prevent the various kinds of deformation of the substrate section 102 by using the plurality of ribs 104x and 104y in a mutually complementary manner.

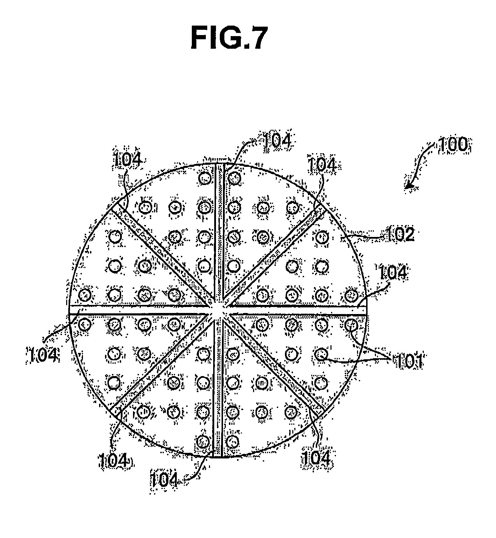

In the wafer level lens array 100 of the modified example shown in Fig. 7, a plurality of ribs 104, which extend radially from the center of the substrate section 102, are provided on the one side surface of the substrate section 102. With such a configuration, with respect to a certain axis, some ribs 104 are parallel to the axis, and some other ribs 104 intersect with the axis. Therefore, the second moment of the area of the substrate section 102 around the axis, and thus the deformation of the substrate section 102 around the axis is prevented. Consequently, as described above, it is possible to prevent the various kinds of deformation of the substrate section 102 by using the plurality of the ribs 104 in a mutually complementary manner.

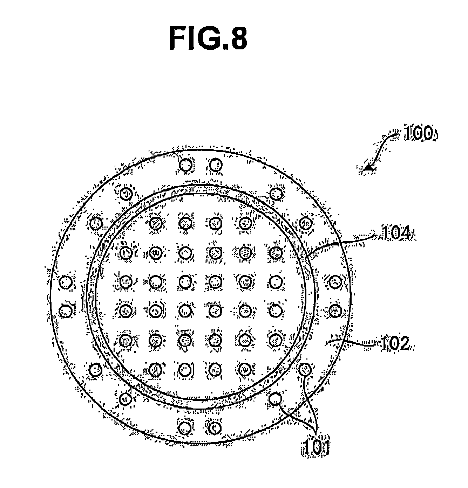

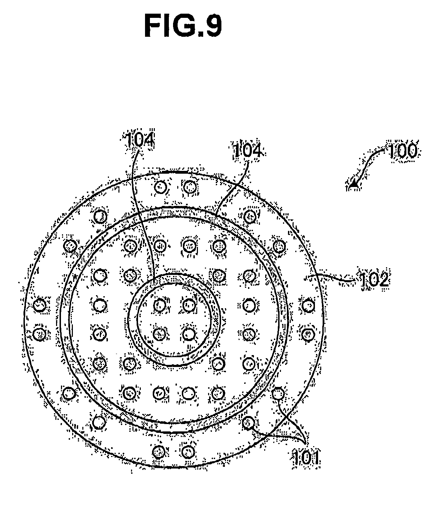

In the wafer level lens array 100 of the modified example shown in Fig. 8, an annular rib 104 is provided on the one side surface of the substrate section 102. With such a configuration, the annular rib 104 has a portion orthogonal to any axis passing through the center of the annular rib 104. Hence, it is possible to increase the second moment of the area of the substrate section 102 around the axes uniformly. That is, it is possible to prevent the various kinds of deformation of the substrate section 102 by using one rib 104. In addition, as shown in Fig. 9, a plurality of annular ribs 104 having different diameters are concentrically arranged. In this case, it is possible to increase further the second moment of the area of the substrate section 102. As a result, it is possible to prevent deformation of the substrate section 102 more reliably. Further, it is possible to arrange linear ribs and annular ribs in a combined manner.

Furthermore, in the description of all the above-mentioned wafer level lens arrays 100, the rib 104 is provided on the one side surface of the substrate section 102, but the rib 104 may be provided on both surfaces of the substrate section 102.

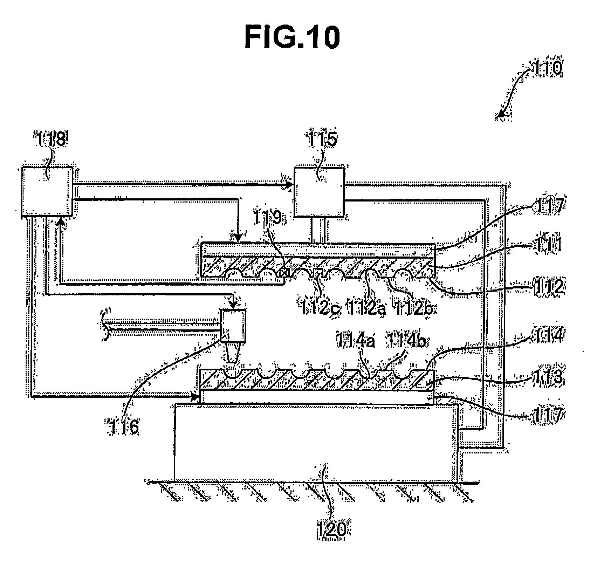

Fig. 10 shows an example of an apparatus for manufacturing the wafer level lens array 100. Furthermore, the following description will be given under the assumption that a thermosetting resin is used as the resin material of the lens sections 101, the substrate section 102, and the rib 104. The manufacturing apparatus 110 shown in Fig. 10 includes an upper mold 111, a lower mold 113, a mechanical section 115, a resin supply section 116, a heating section 117, and a control section 118.

The upper mold 111 has a transfer surface 112 fitted to the upper surface of the wafer level lens array 100. The lens sections 101 of the wafer level lens array 100 shown in Figs. 1A and 1B are two-dimensionally arranged at a predetermined pitch, the lens surfaces 103a of lens sections 101 is included in the upper surface of the wafer level lens array 100, and the lens surfaces 103a are convex spherical surfaces. Accordingly, on the transfer surface 112, the concave spherical surfaces 112a having shapes opposite to the lens surfaces 103a are two-dimensionally arranged at a pitch the same as that of the lens sections 101. Furthermore, the rib 104, which linearly extends along the surface of the substrate section 102, is included in the upper surface of the wafer level lens array 100, and the sectional shape of the rib 104 is trapezoidal. Accordingly, on the transfer surface 112, a concave channel 112c, which linearly extends and has a trapezoidal shape as a shape of the reversed rib 104 in sectional view, is provided. The lower mold 113 also has a transfer surface 114 fitted to the lower surface of the wafer level lens array 100.

The upper mold 111 is provided with a pressure sensor 119 that detects a pressure which is applied to the transfer surface by the contact of the resin material. In the example shown in the drawing, the pressure sensor 119 is provided on a portion, in which the surface of the substrate section 102 of the wafer level lens array 100 is formed, on the transfer surface 112, that is, on a planar surface 112b except the concave spherical surfaces 112a arranged two-dimensionally. Furthermore, the contact between the transfer surface 112 and the resin material having fluidity prior to curing makes the pressure applied to the transfer surface 112 uniforms. Therefore, it is enough to provide just one pressure sensor 119, but it is preferable that a plurality of pressure sensors should be separately arranged on the transfer surface 112. Further, in the example shown in the drawing, the pressure sensor 119 is provided on the upper mold 111. However, the pressure sensor 119 may be provided on the lower mold 113, and may be provided on both of the upper mold 111 and the lower mold 113.

The upper mold 111 and the lower mold 113 are disposed so that the transfer surface 112 and 114 of these are opposed to each other. The lower mold 114 is mounted on a base mount 120 so that its position is fixed. The upper mold 111 is supported by the mechanical section 115. The mechanical section 115 is configured to raise the upper mold 111 so as to widen or narrow the space between the transfer surface 112 of the upper mold 111 and the transfer surface 114 of the lower mold 113. As the mechanism that raises the upper mold 111, it is possible to use an appropriate mechanism such as a ball screw and a cylinder piston.

The resin supply section 116 is configured to supply the resin material on the transfer surface 114 of the lower mold 113. Furthermore, in consideration of the contraction of the resin material caused by the curing thereof, the amount of the supplied resin material is set to be slightly larger than the volume of the wafer level lens array 100.

The heating section 117 is configured to heat the upper mold 111 and the lower mold 113 separately and supply a heat required for the curing to the resin material in contact with the transfer surface 112 of the upper mold 111 and the transfer surface 114 of the lower mold 113. Accordingly, the upper mold 111 and the lower mold 113 are made of metal such as nickel having an excellent thermal conductivity.

The control section 118 is configured to raise the upper mold 111 by driving the mechanical section 115 in response to the pressure which is detected by the pressure sensor 119, and adjust the space between the transfer surface 112 of the upper mold 111 and the transfer surface 114 of the lower mold 113. Further, by controlling the operations of the resin supply section 116 and the heating section 117, the amount of the supplied resin material, the temperatures of the upper mold 111 and the lower mold 113, and the like are also adjusted.

A process of manufacturing the wafer level lens array 100 by using the manufacturing apparatus 110 configured as described above is described below.

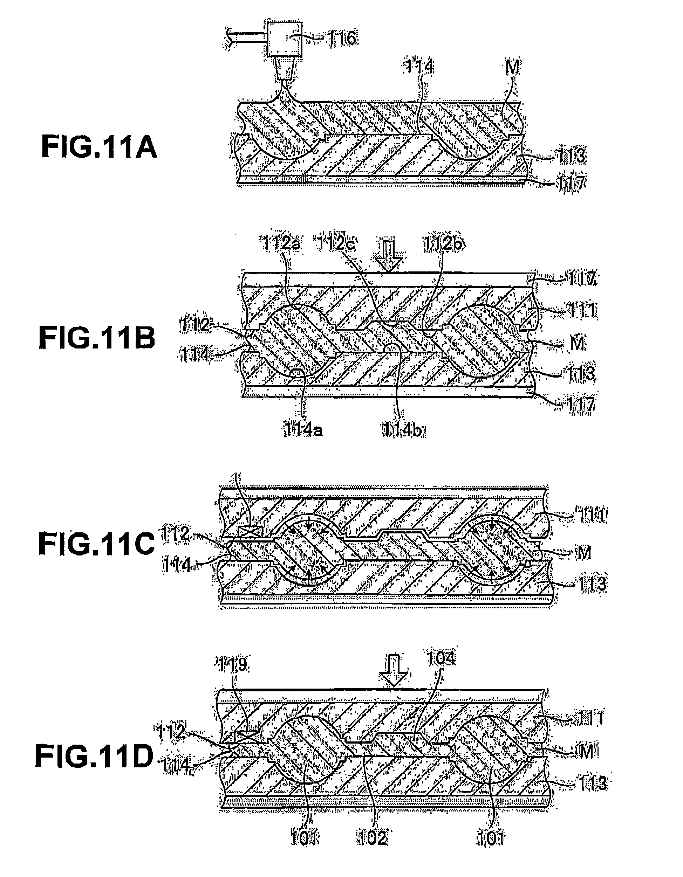

As shown in Fig. 11A, first, the resin supply section 116 supplies the resin material M to the transfer surface 114 of the lower mold 113, and the resin material M spreads over the transfer surface 114 of the lower mold 113. In a case where the fluidity of the resin material M is relatively low, the fluidity is increased by preheating the resin material M in the resin supply section 116, and in this state, the resin material M may be supplied onto the transfer surface 114 of the lower mold 113. In addition, the resin material M on the transfer surface 114 of the lower mold 113 is preheated by allowing the heating section 117 to heat the lower mold 113, and thereby the fluidity of the resin material M may be increased on the transfer surface 114 of the lower mold 113.

Thereafter, as shown in Fig. 11B, the resin material M is spread over the transfer surface 114 of the lower mold 113, and subsequently the resin supply section 116 is moved back from the upper side of the lower mold 113. Then, the upper mold 111 is lowered, and the resin material M is sandwiched between the transfer surface 112 of the upper mold 111 and the transfer surface 114 of the lower mold 113. The resin material M comes into tight contact with the transfer surface 112 of the upper mold 111 and the transfer surface 114 of the lower mold 113, and shapes of both transfer surfaces 112 and 114 are transferred to the resin material M.

Next, the heating section 117 separately heats the upper mold 111 and the lower mold 113, and supplies the heat to the resin material M being in contact with the transfer surface 112 of the upper mold 111 and the transfer surface 114 of the lower mold 113. Thereby, the resin material M is cured in a state where the shape of both transfer surfaces 112 and 114 are transferred. The resin material M, which is sandwiched between the concave spherical surfaces 112a and 114a of both transfer surfaces 112 and 114, form the lens sections 101, which have the lens surfaces 103a and 103b as convex spherical surfaces, on both sides thereof. In addition, the resin material M, which is sandwiched between the planar surfaces 112b and 114b except the concave spherical surfaces of both transfer surfaces 112 and 114, forms the substrate section 102 which connects the lens sections 101 to each other. Further, the resin material M inserted in the concave channel 112c forms the rib 104.

As shown in Fig. 11C, in the process of the curing of the resin material M, the resin material M contracts, the contractile force of the resin material M acts in the direction of separating the resin material M from the transfer surface 112 of the upper mold 111 and the transfer surface 114 of the lower mold 113 (in order to describe the direction of the action of the contractile force of the resin material M, Fig. 11C shows the state, in which both transfer surfaces 112 and 114 are separated from the resin material M, for convenience of description, but it is preferable that both transfer surfaces 112 and 114 should be kept in tight contact with the resin material M without separation therebetween). Thereby, the pressure, which is applied by the contact with the resin material M to the transfer surface 112 of the upper mold 111 and the transfer surface 114 of the lower mold 113, is deteriorated. The fluctuating pressure is detected by the pressure sensor 119 provided on the transfer surface 112 of the upper mold 111, and the signal corresponding to the detected pressure is transmitted from the pressure sensor 119 to the control section 118.

The control section 118 stores a set pressure, which is set in advance, relative to the pressure applied to transfer surface 112 of the upper mold 111 in the process of the curing of the resin material M. The control section 118 lowers the upper mold 111 by driving the mechanical section 115 so as to allow the pressure sensor 119 to detect the stored set pressure on the basis of the signal transmitted by the pressure sensor 119. Accordingly, as shown in Fig. 11D, it is possible to narrow the space between the transfer surface 112 of the upper mold 111 and the transfer surface 114 of the lower mold 113. In addition, both transfer surfaces 112 and 114 are kept in tight contact with the resin material M while changing the shape of the resin material M along both transfer surfaces 112 and 114. As described above, due to the contraction of the resin material M caused by the curing thereof, both transfer surfaces 112 and 114 are kept in tight contact with the resin material M, and the shapes of both transfer surfaces 112 and 114 are accurately transferred. As a result, the lens sections 101 made of the resin material M are formed with high accuracy.

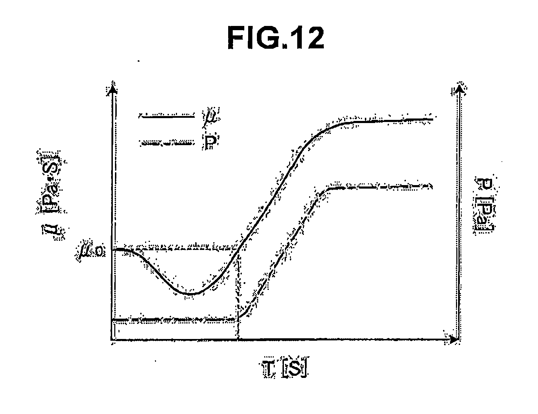

The set pressure, which is stored in the control section 118, may be set to a constant pressure in the process of the curing of the resin material M. The pressure in this case may be generated by driving the mechanical section 115, and may be generated by the weight of the upper mold 111 by itself. Preferably, the set pressure stored in the control section 118 is, as shown in Fig. 12, set to be higher as the resin material M becomes harder. Fig. 12 shows a general relationship between time T and viscosity (hardness) µ of the resin material. Furthermore, the time T corresponds to the amount of accumulated energy applied to the resin material. Besides, Fig. 12 shows the shift of the set pressure P, that is, the shift of the pressure added to the resin material.

As shown in Fig. 12, the viscosity of the resin material M is decreased by the preheating, and subsequently the viscosity is increased as the curing reaction proceeds. The set pressure P gradually becomes higher in accordance with the increase in viscosity of the preheated resin material. As described above, as the resin material M becomes harder, the set pressure P is set to be higher, and thus it is possible accurately to transfer the shapes of the transfer surface 112 of the upper mold 111 and the transfer surface 114 of the lower mold 113 to the resin material M which is gradually cured. Furthermore, in the example shown in the drawing, until the viscosity decreased by the preheating returns to the viscosity µ₀ at room temperature, the set pressure is set to be constant regardless of the increase in viscosity of the resin material M. This is for preventing the resin material M from leaking out from the gap between the upper mold 111 and the lower mold 113 by adding a relatively high pressure to the resin material M of which the viscosity is extremely low.

In the description of the above-mentioned example, the resin material M, which forms the lens sections 101, the substrate section 102, and the rib 104 of the wafer level lens array100, is the thermosetting resin, but may be a photo-curable resin. In this case, the manufacturing apparatus 110 is provided with a light source that irradiates light for advancing the curing reaction of the resin material onto the resin material. In the apparatus, at least one of the upper mold 111 and the lower mold 113 is made of a material such as glass which transmits light emitted from the light source.

The upper mold 111 and the lower mold 113, which are used in the manufacturing apparatus 110, are formed by using masters having the same surface shapes as the wafer level lens array 100. Hereafter, a master for the upper mold 111 and the upper mold 111 formed by using the master will be described.

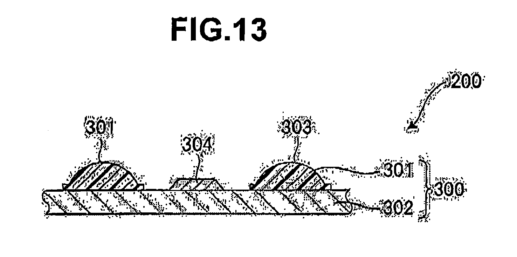

Fig. 13 shows the master of the wafer level lens array 100 shown in Figs. 1A and 1B. The master 200 shown in Fig. 13 is formed by bonding the rib-like member 304 to the master base 300.

The master base 300 includes a substrate section 302, which has an approximately circular shape, and a plurality of curved sections 301 which are two-dimensionally arranged at a predetermined pitch on a surface of the substrate section 302. The shape of the surface of the master base 300 including the curved surfaces 303 corresponding to the surface of the curved section 301 is the same as the shape of the upper surface from which the rib 104 of the wafer level lens array 100 of Figs. 1A and 1B is removed. Accordingly, the curved surface 303 of each curved section 301 of the master base 300 is formed as a convex spherical surface the same as the lens surface 103a of the lens section 101 of the wafer level lens array 100. The curved surface 303 of the curved section 301 of the master base 300 corresponds to the lens surface 103a of the lens section 101 of the wafer level lens array 100. Therefore, hereinafter, the curved section 301 of the master base 300 and the curved surface 303 thereof are respectively referred to as the lens section of the master base 300 and the lens surface thereof.

The substrate section 302 is made of ceramics such as alumina, glass, or the like. The lens section 301 is made of a resin material, and is bonded to the surface of the substrate section 302. As the resin material of the lens section 301, for example, a thermosetting epoxy resin, a thermosetting acryl resin, a photo-curable epoxy resin, a photo-curable acryl resin, or the like is used. Furthermore, since the lens section 301 and the substrate section 302 of the master base 300 do not function as optical elements, the resin material of the lens section 301 and the substrate section 302 of the master base 300 may be not optically transparent.

For example, each lens section 301 is separately formed in a way that the resin material softened on the surface of the substrate section 302 is shaped by the mold having the transfer surface fitted to the lens surface 303. Then, the lens section 301 is bonded to the surface of the substrate section 302 as the resin material is cured. In this case, similarly to the process of manufacturing the wafer level lens array 100 shown in Figs. 11A to 11D, it is preferable to keep the transfer surface of the mold in tight contact with the resin material by narrowing the space between the mold and the substrate section 302 in accordance with contraction of the resin material. Further, the lens section 301, which is formed in advance, may be bonded onto the surface of the substrate section 302, for example, by using an adhesive.

The rib-like member 304 has the same shape as the rib 104 of the wafer level lens array 100, and is formed separately from the master base 300. The rib-like member 304 is made of ceramics such as alumina, glass, or the like. The rib-like member 304 is detachably bonded, for example by using an adhesive having a relatively small adhesive force, to a predetermined portion of the surface of the substrate section 302 of the master base 300, that is, a portion corresponding to the portion, on which the rib 104 is formed, on the surface of the substrate section 102 of the wafer level lens array 100.

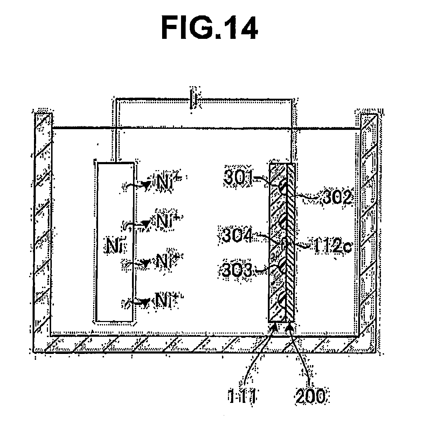

The master 200, which is formed by bonding the rib-like member 304 to the master base 300, has the same surface shape as the upper surface of the wafer level lens array 100 including the rib 104. The upper mold 111 is formed by using the master 200, for example, in the electroforming method. Specifically as shown in Fig. 14, a conductive film is formed on the surface of the master, and the master 200 is dipped into a nickel plating solution. Then, in this state, an electric field is generated therein by setting the conductive film of the surface of the master 200 as a cathode. In such a manner, the nickel is extracted therefrom and is deposited on the surface of the master 200, and the upper mold 111 to which the surface shape of the master 200 is transferred. By using the electroforming method, it is possible to transfer the surface shape of the master 200 to the upper mold 111. On the transfer surface 112 of the upper mold 111, the concave spherical surface 112a is formed by transferring the shape of the lens surface 303 of the master 200, and the concave channel 112c is formed by transferring the shape of the rib-like member 304 of the master 200.

Here, the rib-like member 304, which forms a concave channel 112c on the transfer surface 112 of the upper mold 111, is detachably bonded to the substrate section 302 of the master base 300. Accordingly, by using one master base 300, the arrangement of the rib-like member 304 is variously changed, and thus it is possible to form a plurality of the upper molds 111 in which the arrangement of the concave channel 112c is variously changed. In such a manner, the wafer level lens array 100, in which the arrangement of the rib 104 is variously changed, is experimentally produced, and the deformation of the experimentally produced substrate section 102 is inspected. Thereby, it is possible to arrange the rib 104 in a position appropriate for coping with the deformation of the substrate section 102.

As described, the wafer level lens array according to the embodiment includes: the plurality of lens sections that are one-dimensionally or two-dimensionally arranged; the substrate section that connects the lens sections to each other; and the rib that is disposed on the substrate section and extends along the surface of the substrate section. The lens sections, the substrate section, and the rib are integrally made of the resin material.

With such a configuration of the wafer level lens array, it is possible to increase the second moment of the area of the substrate section around the axis intersecting with the rib. As a result, it is possible to prevent the deformation of the substrate section around the axis.

Further, in the wafer level lens array according to the embodiment, a plurality of the ribs is provided, and the ribs constitute the first group which linearly extends parallel to each other and the second group which linearly extends parallel to each other. In addition, the plurality of the ribs included in the first group intersects with the plurality of the ribs included in the second group. With such a configuration of the wafer level lens array, it is possible to prevent various kinds of deformation of the substrate section by using the plurality of ribs belonging to the first and second groups in a mutually complementary manner.

Furthermore, in the wafer level lens array according to the embodiment, a plurality of the ribs is provided, and the ribs extend radially from the center of the substrate section. With such a configuration of the wafer level lens array, with respect to a certain axis, some ribs are parallel to the axis, and some other ribs intersect with the axis. Therefore, the second moment of the area of the substrate section around the axis, and thus the deformation of the substrate section around the axis is prevented. Consequently, it is possible to prevent the various kinds of deformation of the substrate section by using the plurality of the ribs in a mutually complementary manner.

Further, in the wafer level lens array according to the embodiment, the rib has an annular shape. With such a configuration of the wafer level lens array, the annular rib has a portion orthogonal to any axis passing through the center of the annular rib. Hence, it is possible to increase the second moment of the area of the substrate section around the axes uniformly. That is, it is possible to prevent the various kinds of deformation of the substrate section by using one rib.

Furthermore, in the wafer level lens array according to the embodiment, the plurality of the ribs are provided, and the ribs are concentrically arranged. With such a configuration of the wafer level lens array, it is possible to increase further the second moment of the area of the substrate section. As a result, it is possible to prevent deformation of the substrate section more reliably.

Further, in the wafer level lens array according to the embodiment, the angle formed between the side surface of the rib and the surface of the substrate section is an obtuse angle. With such a configuration of the wafer level lens array, it is possible easily to demold the rib from the mold for shaping the resin material.

Furthermore, in the wafer level lens array according to the embodiment, at least one side lens surface of each lens section is convex. In addition, the rib is provided on the surface of the substrate section closer to the lens surface which is convex, and the height of the rib from the surface of the substrate section is lower than that of the lens surface. With such a configuration of the wafer level lens array, in a case where the wafer level lens array is combined with the sensor array or another wafer level lens array in an overlapped manner in the process of manufacturing the image pickup unit, there is no restriction on the space between the lens surface of the lens section and another wafer level lens array or the sensor array.

Further, according to another embodiment, there is provided a method of manufacturing the wafer level lens array including the plurality of lens sections that are one-dimensionally or two-dimensionally arranged, the substrate section that connects the lens sections to each other, and the rib that is disposed on the substrate section and extends along the surface of the substrate section. The lens sections, the substrate section, and the rib are integrally made of the resin material. The method includes the steps of: forming the master that has the same shape as the wafer level lens array; forming the first mold that has the transfer surface fitted to one side surface of the master and the second mold that has the transfer surface fitted to the opposite side surface of the master; and curing the resin material that is softened between the transfer surface of the first mold and the transfer surface of the second mold.

In the manufacturing method of the wafer level lens array, the wafer level lens array is manufactured in a way that the molds therefor are formed by the master having the same surface shape and the resin material is shaped by the molds. By variously modifying the shape and the arrangement of the rib of the master, it is possible to variously modify the shape and the position of the rib of the wafer level lens array. As a result, it is possible to manufacture a wafer level lens array suitable for preventing the substrate section from being deformed.

Furthermore, in the method of manufacturing the wafer level lens array, the master base having the same shape as the wafer level lens array, from which the rib is removed, is formed, and the rib-like member corresponding to the rib is bonded to the master base so as to form the master. In the manufacturing method of the wafer level lens array, by variously modifying the arrangement and the shape of the rib-like member, it is possible easily to form various masters in which the arrangement and the shape of the rib are variously modified on the basis of one master base.

Further, in the method of manufacturing the wafer level lens array, the rib-like member is detachably bonded to the master base. In the manufacturing method of the wafer level lens array, it is possible easily to form various masters in which the arrangement and the shape of the rib are variously modified by using one master base.

## Claims

1. A wafer level lens array comprising:
a plurality of lens sections that are one-dimensionally or two-dimensionally arranged;
a substrate section that connects the lens sections to each other; and
a rib that is disposed on the substrate section and extends along the surface of the substrate section,
wherein the lens sections, the substrate section, and the rib are integrally made of a resin material.

2. The wafer level lens array according to claim 1, wherein a plurality of the ribs are provided, and the ribs constitute a first group which linearly extends in parallel to each other and a second group which linearly extends in parallel to each other, and
wherein the plurality of the ribs included in the first group intersect with the plurality of the ribs included in the second group.

3. The wafer level lens array according to claim 1, wherein a plurality of the ribs are provided, and the ribs extend radially from the center of the substrate section.

4. The wafer level lens array according to claim 1, wherein the rib has an annular shape.

5. The wafer level lens array according to claim 4, wherein a plurality of the ribs are provided, and the ribs are concentrically arranged.

6. The wafer level lens array according to any one of claims 1 to 5, wherein an angle formed between a side surface of the rib and the surface of the substrate section is equal to or larger than a right angle.

7. The wafer level lens array according to any one of claims 1 to 6,
wherein at least one side lens surface of each lens section is convex, and
wherein the rib is provided on the surface of the substrate section closer to the lens surface which is convex, and a height of the rib from the surface of the substrate section is lower than that of the lens surface.

8. A method of manufacturing a wafer level lens array including a plurality of lens sections that are one-dimensionally or two-dimensionally arranged, a substrate section that connects the lens sections to each other, and a rib that is disposed on the substrate section and extends along the surface of the substrate section, in which the lens sections, the substrate section, and the rib are integrally made of a resin material, the method comprising the steps of:
forming a master that has the same shape as the wafer level lens array;
forming a first mold that has a transfer surface fitted to one side surface of the master and a second mold that has a transfer surface fitted to an opposite side surface of the master; and
curing the resin material that is softened between the transfer surface of the first mold and the transfer surface of the second mold.

9. The method of manufacturing the wafer level lens array according to claim 8,
wherein a master base having the same shape as the wafer level lens array, from which the rib is removed, is formed, and
wherein a rib-like member corresponding to the rib is bonded to the master base so as to form the master.

10. The method of manufacturing the wafer level lens array according to claim 9, wherein the rib-like member is detachably bonded to the master base.
